# FASCICULE DE BREVET EUROPEEN

(11) **EP 4 619 265 B1**
(45) Date de publication et mention de la délivrance du brevet: **09.12.2026**
(21) Numéro de dépôt: 23793304.9
(22) Date de dépôt: 17.10.2023
(51) Int. Cl.: B60K 35/10, G09F 13/04, G09F 13/08, G09F 13/10, G09F 13/14, B60K 35/00, B60K 35/21

(54) **MODULE DE COMMANDE ÉCLAIRÉ POUR VÉHICULE AUTOMOBILE**
BELEUCHTETES STEUERMODUL FÜR KRAFTFAHRZEUG
ILLUMINATED CONTROL MODULE FOR MOTOR VEHICLE

(30) Priorité: 18.11.2022 FR 2212002
(43) Date de publication de la demande: 24.09.2025
(73) Titulaire: DAV, 94000 Créteil (FR)
(72) Inventeur: FAVRE, Thibaud, 94000 Créteil (FR); BERRY, Martial, 94000 Créteil (FR)
(74) Mandataire: Delplanque, Arnaud
(86) Numéro de dépôt international: PCT/EP2023/078873
(87) Numéro de publication internationale: WO 2024/104685

(56) Documents cités:
- DE-A1- 102019 107 358
- FR-A1- 3 109 916
- US-A1- 2021 347 297

## Description

L'invention concerne un module de commande éclairé pour véhicule automobile.

Dans l'habitacle d'un véhicule, on utilise des modules de commande permettant à l'utilisateur de commander des systèmes embarqués du véhicule.

Certains modules de commande sont en outre pourvus de capteurs capacitifs équipés d'antennes capacitives pour détecter l'approche du doigt de l'utilisateur à proximité de l'interface. Cette détection d'approche peut permettre d'activer l'interface avant que l'utilisateur ne contacte l'interface.

Le module de commande permet à l'utilisateur, conducteur ou passager, qui l'actionne, de commander des systèmes embarqués du véhicule tels que le système de climatisation, de radio, de musique, du téléphone, de ventilation ou de navigation.

En général, le module de commande comprend une façade comportant des pictogrammes situés à proximité d'organes de commande. On connaît déjà de l'état de la technique un tel module de commande comprenant un circuit imprimé flexible portant des antennes capacitives pour détecter l'approche du doigt de l'utilisateur. Dans ce module de l'état de la technique, le circuit imprimé, fixé à une plaque intérieure d'une façade du module, intègre des diodes électroluminescentes pour le rétroéclairage du pictogramme. A titre d'exemple, on peut ainsi commander le rétroéclairage par détection capacitive afin de faciliter le choix du pictogramme et de l'organe de commande qui lui est associé, par exemple en conduite de nuit. Dans ce module de l'état de la technique, on utilise des diodes électroluminescentes à émission latérale, c'est-à-dire avec une face émettrice latérale par rapport au support de la diode.

De telles diodes à émission latérale (également connues sous l'acronyme EELD) sont par exemple connues du document EP3161912A1, du document FR3109916 ou du document FR3022869. De telles diodes sont formées d'un empilement de couches semi-conductrices avec différents dopages et conçues de manière que l'émission de lumière se fait latéralement par rapport à l'empilement des couches, d'où le nom « à émission latérale ».

Cependant dans ce module de l'état de la technique, l'éclairage des pictogrammes et autres surfaces à éclairer n'est pas suffisamment homogène. De plus, les diodes à émission latérale sont plus complexes dans leur structure et donc associées à un coût de fabrication plus élevé. De plus, l'utilisation de diodes à émission latérale nécessite l'utilisation de guides de lumière, ce qui augmente aussi le coût de revient. Par ailleurs, du fait de la proximité entre les diodes et les antennes capacitives, les diodes parasitent le tionnement du module. La présence des diodes sous la façade entraine un effet de retassures visibles en surface du module, responsable d'un aspect non homogène du module, qui peut aboutir à sa mise au rebus. L'utilisation des diodes à émission latérale est aussi associée à un encombrement horizontal important car les diodes à émission latérale doivent être suffisamment espacées pour obtenir un éclairage homogène sur toute la surface. Enfin, pour contrôler l'homogénéité lumineuse, il est nécessaire d'utiliser plusieurs diodes pour un seul pictogramme.

L'invention a notamment pour but de proposer un module de commande éclairé pour véhicule automobile amélioré qui s'affranchit au moins partiellement des inconvénients cités ci-dessus.

A cet effet l'invention a pour objet un module de commande éclairé pour véhicule automobile, le module comprenant :
- une façade comprenant une couche extérieure comprenant au moins un pictogramme,
- au moins un organe de commande,
- un circuit imprimé flexible, fixé à une plaque intérieure de la façade, et comportant au moins une antenne capacitive destinée à détecter l'approche d'un objet vers l'organe de commande,

dans lequel le pictogramme est situé en regard de l'antenne capacitive,
le circuit imprimé flexible intégrant au moins une diode électroluminescente pour le rétroéclairage du pictogramme,
dans lequel :
   - la diode électroluminescente est à émission par le haut,
   - la diode électroluminescente est disposée sur une partie d'extrémité du circuit imprimé flexible, qui est destinée à être fixée sur une pièce de la façade, perpendiculaire à une pièce de la façade comprenant le pictogramme,
le module de commande comprend également un réflecteur de lumière disposé en vis-à-vis du pictogramme, de manière qu'une majeure partie d'un faisceau lumineux émis par la diode soit réfléchie par le réflecteur de lumière vers le pictogramme.

Ainsi la diode n'est pas située sous le pictogramme. Ceci permet d'imposer une distance minimale entre la diode et l'antenne capacitive, limitant ainsi l'effet parasite de la diode sur l'antenne. Ceci évite également que des retassures soient visibles depuis l'extérieur du module.

Une diode à émission par le haut (également connues en anglais sous l'expression « top-emitting LED ») est une diode « standard ». Il s'agit des LED standards les moins chères. Ces LED standards sont également fabriquées par un empilement de couches semi-conductrices, mais l'émission d'un cône de lumière se fait par le haut de cet empilement, d'où l'expression an anglais « top-emitting LED ». Elle se distingue d'une diode à émission latérale par son cône, en ce que la face émettrice de lumière de la diode est celle qui se trouve au sommet de l'empilement des couches semi-conductrices. De telles diodes à émission par le haut sont par exemple connues du document FR3064531.

« Une majeure partie d'un faisceau lumineux » correspond au moins à la moitié du faisceau lumineux.

Selon un aspect, la pièce de la façade perpendiculaire à la pièce comprenant le pictogramme, est par exemple une zone de fixation de la façade à un boîtier support de celle-ci.

La pièce de la façade perpendiculaire à la pièce comprenant le pictogramme peut être réalisée en matière opaque à la lumière, par exemple en polycarbonate noir.

Selon un autre aspect, le circuit imprimé flexible est transparent à la lumière.

Le circuit imprimé flexible peut être fixé à la plaque intérieure de la façade par surmoulage, collage ou toute autre méthode d'assemblage.

Suivant d'autres caractéristiques optionnelles du module de commande éclairé, prises seules ou en combinaison :

Le circuit imprimé flexible est par exemple fixé à la plaque intérieure de la façade par surmoulage.

On évite ainsi une étape de collage. Par ailleurs, la colle pourrait réduire la sensibilité de détection de l'antenne capacitive et pourrait être un obstacle à la diffusion de la lumière vers le pictogramme.

Le surmoulage est notamment réalisé dans une matière transparente à la lumière, par exemple du polycarbonate blanc.

Le circuit imprimé flexible est fixé notamment dans la plaque intérieure de la façade par surmoulage.

La diode électroluminescente est par exemple partiellement surmoulée dans la plaque intérieure de façon que sa face émettrice soit affleurante, c'est-à-dire qu'elle n'est pas recouverte par la matière de la plaque intérieure.

La couche extérieure peut être fabriquée en un matériau opaque à la lumière, par exemple du polycarbonate noir, et le pictogramme peut être fabriqué dans un matériau transparent ou translucide à la lumière, par exemple du polycarbonate blanc.

La façade comprend par exemple une plaque de diffusion de la lumière, interposée entre la couche extérieure et le circuit imprimé flexible.

On comprend que la plaque de diffusion de la lumière est notamment fabriquée en un matériau transparent ou translucide à la lumière, par exemple du polycarbonate blanc.

La plaque de diffusion permet d'homogénéiser la lumière réfléchie vers le pictogramme.

Le pictogramme est notamment situé sur une face extérieure de la couche extérieure et un fût de diffusion s'étend dans la couche extérieure, depuis la plaque de diffusion jusqu'au pictogramme.

Le fût de diffusion peut être venu de matière avec la plaque de diffusion, notamment venu de moulage. De façon optionnelle, le fût de diffusion est fait d'un seul tenant avec la plaque de diffusion.

La couche extérieure est notamment fabriquée par bi-injection d'un matériau transparent ou translucide à la lumière pour réaliser le pictogramme, et d'un matériau opaque à la lumière pour réaliser la partie de la couche extérieure qui n'est pas le pictogramme.

La plaque de diffusion et le fût de diffusion sont par exemple fabriqués par bi-injection du matériau transparent ou translucide à la lumière.

La couche extérieure est un film décoratif plastique.

Le film est par exemple en polycarbonate.

De façon optionnelle le pictogramme est imprimé sur le film décoratif plastique.

De façon optionnelle le pictogramme est obtenu par grattage du film décoratif plastique.

Le pictogramme peut être obtenu par gravure laser.

Le film décoratif plastique peut être surmoulé sur la plaque intérieure.

La couche extérieure peut également être un revêtement de peinture, notamment opaque, par exemple de la peinture noire. Le pictogramme pourra être obtenu sur le revêtement de peinture par les mêmes méthodes que celles mentionnées pour le film décoratif plastique.

Le réflecteur de lumière est disposé en déport de la diode électroluminescente.

Cela signifie que le réflecteur n'est pas situé en vis-à-vis de la diode, et les rayons lumineux émis par la diode, qui atteignent le réflecteur, sont des rayons formant un angle non nul avec un axe longitudinal d'un faisceau lumineux émis par la diode.

Le réflecteur est par exemple une pièce en matière plastique blanche ou un miroir.

Le réflecteur de lumière comprend au moins une partie située en vis-à-vis de la diode électroluminescente et une partie du faisceau lumineux émis par la diode électroluminescente diffuse dans le réflecteur de lumière pour être réfléchie sur une surface du réflecteur de lumière, puis être diffusée dans le réflecteur vers le pictogramme.

La diffusion dans le réflecteur permet d'éclairer de façon plus homogène le pictogramme.

### Brève description des figures

L'invention sera mieux comprise à la lecture de la description qui va suivre donnée uniquement à titre d'exemple et faite en se référant aux dessins annexés dans lesquels :
[Fig.1] est une vue schématique d'un module de commande éclairé selon un premier mode de réalisation de l'invention ;
[Fig.2] est une vue schématique d'un module de commande éclairé selon un deuxième mode de réalisation de l'invention ;
[Fig.3] est une vue schématique d'un module de commande éclairé selon un troisième mode de réalisation de l'invention.

### Description détaillée

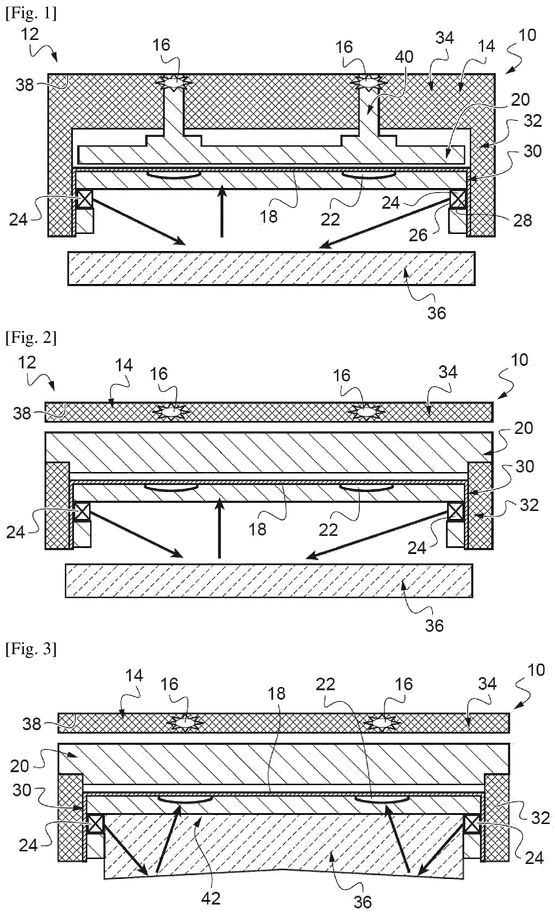

On a représenté sur la [Fig.1] un module de commande éclairé pour véhicule automobile selon un premier mode de réalisation de l'invention, désigné par la référence générale 10. Le module de commande 10 comprend une façade 12 et au moins un organe de commande non représenté. La façade 12 donne accès à un utilisateur à l'organe de commande. La façade 12 est rigide, par exemple réalisée en matière plastique. Elle a notamment une fonction décorative. L'organe de commande permet à l'utilisateur conducteur ou passager qui l'actionne, de commander au moins un système embarqué du véhicule tel que le système de climatisation, de radio, de musique, du téléphone, de ventilation ou de navigation. La façade 12 comprend une couche extérieure 14 qui comprend au moins un symbole, ou pictogramme 16, deux pictogrammes dans l'exemple représenté. Les pictogrammes 16 sont en correspondance avec au moins un organe de commande respectif.

Le module de commande 10 comprend également un circuit imprimé flexible 18, fixé à une plaque intérieure 20 de la façade 12. Le circuit imprimé flexible 18 comporte au moins une antenne capacitive 22, deux antennes capacitives dans l'exemple représenté. L'antenne capacitive 22 permet de détecter l'approche d'un objet, non représenté, tel qu'un ou plusieurs doigts ou la paume de la main de l'utilisateur, à proximité de l'organe de commande, par exemple à partir d'une distance de l'ordre de 40 millimètres. Cette détection peut permettre d'activer le module de commande avant que l'utilisateur n'entre en contact avec celui-ci. Le pictogramme 16 est situé en regard de l'antenne capacitive 22.

Le circuit imprimé 18 intègre au moins une diode électroluminescente 24 pour le rétroéclairage du pictogramme 16. La diode électroluminescente 24 est à émission par le haut où « top emitting LED » en anglais. Ces diodes à émission par le haut comprennent un empilement de couches semi-conductrices et l'émission d'un cône de lumière se fait par le haut de cet empilement d'où l'expression an anglais « top-emitting LED ». Elle se distingue d'une diode à émission latérale par son cône, en ce que la face émettrice de lumière de la diode est celle qui se trouve au sommet de l'empilement des couches semi-conductrices. De telles diodes à émission par le haut sont par exemple connues du document FR3064531.

Dans le présent mode de réalisation, la face émettrice 26 de la diode 24 est positionnée parallèlement par rapport au support 28 de la diode 24.

La diode électroluminescente 24 est disposée sur une partie d'extrémité 30 du circuit imprimé flexible 18. La partie d'extrémité 30 est destinée à être fixée sur une pièce 32 de la façade 12, perpendiculaire à une pièce 34 de la façade 12, laquelle comprend le pictogramme 16. Dans l'exemple de la [Fig.1], les pièces 32 et 34 forment une seule et même pièce. La pièce 32 de la façade perpendiculaire à la pièce 34 comprenant le pictogramme, dite « pièce perpendiculaire », est par exemple une zone de fixation de la façade 12 à un boîtier support de celle-ci, non représenté. Dans l'exemple représenté, la pièce perpendiculaire 34 est réalisée en matière opaque à la lumière, par exemple en polycarbonate noir. Dans l'exemple, le circuit imprimé 18 est transparent à la lumière.

Le module 10 comprend également un réflecteur de lumière 36 disposé en vis-à-vis du pictogramme 16, de manière qu'une majeure partie d'un faisceau lumineux émis par la diode 24 soit réfléchie par le réflecteur de lumière 36 vers le pictogramme 16. Cette partie du faisceau lumineux réfléchie par le réflecteur de lumière 36 vers le pictogramme 16 est symbolisée par les trois flèches.

Dans l'exemple de la [Fig.1], le circuit imprimé 18 est fixé à la plaque intérieure 20 de la façade 12 par surmoulage. Plus précisément le circuit imprimé 18 est fixé dans la plaque intérieure 20 de la façade 12 par surmoulage. La diode 24 est partiellement surmoulée dans la plaque intérieure 20 de façon que sa face émettrice 26 soit affleurante, c'est-à-dire qu'elle n'est pas recouverte par la matière de la plaque intérieure 20.

De plus, la couche extérieure 14 est fabriquée en un matériau opaque à la lumière, par exemple du polycarbonate noir, et le pictogramme 16 est fabriqué dans un matériau transparent ou translucide à la lumière, par exemple du polycarbonate blanc.

Par ailleurs, la façade 12 comprend une plaque de diffusion de la lumière, interposée entre la couche extérieure 14 et le circuit imprimé 18. Dans l'exemple de la [Fig.1], la plaque de diffusion est la plaque intérieure 20. La plaque 20 de diffusion de la lumière est fabriquée en un matériau transparent ou translucide à la lumière, par exemple du polycarbonate blanc. Elle permet d'homogénéiser la lumière réfléchie vers le pictogramme 16.

Egalement dans l'exemple de la [Fig.1], le pictogramme 16 est situé sur une face extérieure 38 de la couche extérieure 14 et un fût de diffusion 40 s'étend dans la couche extérieure 14, depuis la plaque de diffusion 20 jusqu'au pictogramme 16. Le fût de diffusion 40 est venu de matière avec la plaque de diffusion 20. Il est venu de moulage avec la plaque de diffusion 20. Il est fait d'un seul tenant avec la plaque de diffusion 20.

La couche extérieure 14 est fabriquée par bi-injection d'un matériau transparent ou translucide à la lumière pour réaliser le pictogramme 16, et d'un matériau opaque à la lumière pour réaliser la partie de la couche extérieure qui n'est pas le pictogramme 16.

La fabrication de la couche extérieure 14 par bi-injection permet également la fabrication de la plaque de diffusion 20 et du fût de diffusion 40.

Le réflecteur de lumière 36 est disposé en déport de la diode électroluminescente 24. Ainsi le réflecteur 36 n'est pas situé en vis-à-vis de la diode 24, et les rayons lumineux émis par la diode 24, qui atteignent le réflecteur 36, sont des rayons formant un angle non nul avec un axe longitudinal d'un faisceau lumineux émis par la diode 24. Le réflecteur 36 est par exemple une pièce en matière plastique blanche ou un miroir.

On a représenté sur la [Fig.2] un module de commande éclairé 10 pour véhicule automobile selon un deuxième mode de réalisation de l'invention.

Sur cette [Fig.2], ainsi que sur la [Fig.3], les éléments analogues à ceux de la [Fig.1] sont désignés par des références identiques.

Dans cet exemple ainsi que dans l'exemple de la [Fig.3], la couche extérieure 14 est un film décoratif plastique, plus particulièrement en polycarbonate. Le film est surmoulé sur la plaque intérieure 20. Le pictogramme 16 est obtenu par grattage du film. Il pourrait également être obtenu par impression du pictogramme 16 sur le film.

Par ailleurs dans l'exemple de la [Fig.3], le réflecteur 36 comprend au moins une partie 42 située en vis-à-vis de la diode 24, et une partie du faisceau lumineux émis par la diode diffuse dans le réflecteur 36 pour être réfléchie sur une surface 44 du réflecteur 36, puis être diffusée dans le réflecteur 36 vers le pictogramme 16. La diffusion dans le réflecteur 36 permet d'éclairer de façon plus homogène le pictogramme 16.

### Liste de références

10 : module de commande
12 : façade
14 : couche extérieure de la façade
16 : pictogramme
18 : circuit imprimé flexible
20 : plaque intérieure de la façade
22 : antenne capacitive
24 : diode électroluminescente
26 : face émettrice de la diode
28 : support de la diode
30 : partie d'extrémité du circuit imprimé
32 : pièce perpendiculaire
34 : pièce comprenant le pictogramme
36 : réflecteur de lumière
38 : face extérieure de la couche extérieure
40 : fût de diffusion
42 : partie du réflecteur disposée en vis-à-vis de la diode

## Revendications

1. Module de commande éclairé (10) pour véhicule automobile, le module (10) comprenant :
- une façade (12) comprenant une couche extérieure (14) comprenant au moins un pictogramme (16),
- au moins un organe de commande,
- un circuit imprimé flexible (18), fixé à une plaque intérieure (20) de la façade (12), et comportant au moins une antenne capacitive (22) configurée pour détecter l'approche d'un objet vers l'organe de commande, dans lequel le pictogramme (16) est situé en regard de l'antenne capacitive (22),
le circuit imprimé flexible (18) intégrant au moins une diode électroluminescente (24) configurée pour un rétroéclairage du pictogramme (16),
dans lequel :
- la diode électroluminescente (24) est à émission par le haut,
- la diode électroluminescente (24) est disposée sur une partie d'extrémité (30) du circuit imprimé flexible (18) qui est fixée sur une pièce (32) de la façade (12), perpendiculaire à une pièce (34) de la façade comprenant le pictogramme (16),
**caractérisé en ce que** le module de commande (10) comprend également un réflecteur de lumière (36) disposé en vis-à-vis du pictogramme (16), de manière qu'une majeure partie d'un faisceau lumineux émis par la diode électroluminescente (24) soit réfléchie par le réflecteur de lumière (36) vers le pictogramme (16).

2. Module de commande éclairé (10) selon la revendication précédente, dans lequel le circuit imprimé flexible (18) est fixé à la plaque intérieure (20) de la façade (12) par surmoulage.

3. Module de commande éclairé (10) selon l'une quelconque des revendications précédentes, dans lequel la couche extérieure (14) est fabriquée en un matériau opaque à la lumière, par exemple du polycarbonate noir, et le pictogramme (16) est fabriqué dans un matériau transparent ou translucide à la lumière, par exemple du polycarbonate blanc.

4. Module de commande éclairé (10) selon l'une quelconque des revendications précédentes, dans lequel la façade (12) comprend une plaque de diffusion de la lumière (20), interposée entre la couche extérieure (14) et le circuit imprimé flexible (18).

5. Module de commande éclairé (10) selon la revendication précédente, dans lequel le pictogramme (16) est situé sur une face extérieure (38) de la couche extérieure (14) et un fût de diffusion (40) s'étend dans la couche extérieure (14), depuis la plaque de diffusion (20) jusqu'au pictogramme (16).

6. Module de commande éclairé (10) selon la revendication précédente, dans lequel le fût de diffusion (40) est venu de matière avec la plaque de diffusion (20), par exemple venu de moulage.

7. Module de commande éclairé (10) selon l'une quelconque des revendications précédentes, dans lequel la couche extérieure (14) est fabriquée par bi-injection d'un matériau transparent ou translucide à la lumière pour réaliser le pictogramme (16), et d'un matériau opaque à la lumière pour réaliser la partie de la couche extérieure (14) qui n'est pas le pictogramme.

8. Module de commande éclairé (10) selon la revendication 7 prise en combinaison avec les revendications 5 ou 6, dans lequel la plaque de diffusion (20) et le fût de diffusion (40) sont fabriqués par bi-injection du matériau transparent ou translucide à la lumière.

9. Module de commande éclairé (10) selon l'une quelconque des revendications 1 à 4, dans lequel la couche extérieure (14) est un film décoratif plastique.

10. Module de commande éclairé (10) selon l'une quelconque des revendications précédentes, dans lequel le réflecteur de lumière (36) est disposé en déport de la diode électroluminescente (24).

11. Module de commande éclairé (10) selon l'une quelconque des revendications 1 à 9, dans lequel le réflecteur de lumière (36) comprend au moins une partie (42) située en vis-à-vis de la diode électroluminescente (24) et une partie du faisceau lumineux émis par la diode électroluminescente (24) diffuse dans le réflecteur de lumière (36) pour être réfléchie sur une surface du réflecteur de lumière, puis être diffusée dans le réflecteur de lumière (36) vers le pictogramme (16).

## Patentansprüche

1. Beleuchtetes Steuermodul (10) für ein Kraftfahrzeug, wobei das Modul (10) umfasst:
- eine Blende (12) mit einer Außenschicht (14), die mindestens ein Piktogramm (16) umfasst,
- mindestens ein Steuerelement,
- eine flexible Leiterplatte (18), die an einer Innenplatte (20) der Blende (12) befestigt ist und mindestens eine kapazitive Antenne (22) aufweist, die konfiguriert ist, um die Annäherung eines Objekts an das Steuerelement zu erkennen, wobei das Piktogramm (16) der kapazitiven Antenne (22) gegenüberliegend angeordnet ist, wobei die flexible Leiterplatte (18) mindestens eine Leuchtdiode (24) integriert, die für eine Hintergrundbeleuchtung des Piktogramms (16) konfiguriert ist, wobei:
- die Leuchtdiode (24) eine Top-Emitter-Diode ist,
- die Leuchtdiode (24) an einem Endabschnitt (30) der flexiblen Leiterplatte (18) angeordnet ist, der an einem Teil (32) der Blende (12) befestigt ist, der senkrecht zu einem Teil (34) der Blende steht, der das Piktogramm (16) enthält, **dadurch gekennzeichnet, dass** das Steuermodul (10) auch einen Lichtreflektor (36) umfasst, der dem Piktogramm (16) gegenüberliegend angeordnet ist, sodass ein Großteil eines von der Leuchtdiode (24) emittierten Lichtstrahls vom Lichtreflektor (36) in Richtung des Piktogramms (16) reflektiert wird.

2. Beleuchtetes Steuermodul (10) nach dem vorhergehenden Anspruch, wobei die flexible Leiterplatte (18) durch Umspritzen an der Innenplatte (20) der Blende (12) befestigt ist.

3. Beleuchtetes Steuermodul (10) nach einem der vorhergehenden Ansprüche, wobei die Außenschicht (14) aus einem lichtundurchlässigen Material, beispielsweise schwarzem Polycarbonat, hergestellt ist und das Piktogramm (16) aus einem lichtdurchlässigen oder lichtteildurchlässigen Material, beispielsweise weißem Polycarbonat, hergestellt ist.

4. Beleuchtetes Steuermodul (10) nach einem der vorhergehenden Ansprüche, wobei die Blende (12) eine Lichtdiffusionsplatte (20) umfasst, die zwischen der Außenschicht (14) und der flexiblen Leiterplatte (18) angeordnet ist.

5. Beleuchtetes Steuermodul (10) nach dem vorhergehenden Anspruch, wobei das Piktogramm (16) auf einer Außenfläche (38) der Außenschicht (14) angeordnet ist und ein Diffusionsschaft (40) sich in der Außenschicht (14) von der Diffusionsplatte (20) bis zum Piktogramm (16) erstreckt.

6. Beleuchtetes Steuermodul (10) nach dem vorhergehenden Anspruch, wobei der Diffusionsschaft (40) einstückig mit der Diffusionsplatte (20) ausgeführt ist, beispielsweise durch Spritzguss.

7. Beleuchtetes Steuermodul (10) nach einem der vorhergehenden Ansprüche, wobei die Außenschicht (14) durch Zwei-Komponenten-Spritzguss hergestellt wird, wobei ein lichtdurchlässiges oder lichtteildurchlässiges Material zur Herstellung des Piktogramms (16) und ein lichtundurchlässiges Material zur Herstellung des Teils der Außenschicht (14) verwendet wird, der nicht das Piktogramm ist.

8. Beleuchtetes Steuermodul (10) nach Anspruch 7 in Kombination mit Anspruch 5 oder 6, wobei die Diffusionsplatte (20) und der Diffusionsschaft (40) durch Zwei-Komponenten-Spritzguss des lichtdurchlässigen oder lichtteildurchlässigen Materials hergestellt werden.

9. Beleuchtetes Steuermodul (10) nach einem der Ansprüche 1 bis 4, wobei die Außenschicht (14) eine dekorative Kunststofffolie ist.

10. Beleuchtetes Steuermodul (10) nach einem der vorhergehenden Ansprüche, wobei der Lichtreflektor (36) versetzt zur Leuchtdiode (24) angeordnet ist.

11. Beleuchtetes Steuermodul (10) nach einem der Ansprüche 1 bis 9, wobei der Lichtreflektor (36) mindestens einen Teil (42) umfasst, der der Leuchtdiode (24) gegenüberliegend angeordnet ist, und ein Teil des von der Leuchtdiode (24) emittierten Lichtstrahls im Lichtreflektor (36) streut, um an einer Oberfläche des Lichtre-flektors reflektiert und anschließend im Lichtreflektor (36) in Richtung des Piktogramms (16) gestreut zu werden.

## Claims

1. Illuminated control module (10) for a motor vehicle, the module (10) comprising:
- a fascia (12) comprising an outer layer (14) comprising at least one pictogram (16),
- at least one control member,
- a flexible printed circuit (18), fixed to an inner plate (20) of the fascia (12), and comprising at least one capacitive antenna (22) configured to detect the approach of an object towards the control member, wherein the pictogram (16) is located facing the capacitive antenna (22), the flexible printed circuit (18) integrating at least one light-emitting diode (24) configured for backlighting of the pictogram (16), wherein:
- the light-emitting diode (24) is a top-emitting type,
- the light-emitting diode (24) is arranged on an end portion (30) of the flexible printed circuit (18) which is fixed to a part (32) of the fascia (12), perpendicular to a part (34) of the fascia comprising the pictogram (16), **characterised in that** the control module (10) also comprises a light reflector (36) arranged facing the pictogram (16), such that a major portion of a light beam emitted by the light-emitting diode (24) is reflected by the light reflector (36) towards the pictogram (16).

2. Illuminated control module (10) according to the preceding claim, wherein the flexible printed circuit (18) is fixed to the inner plate (20) of the fascia (12) by overmoulding.

3. Illuminated control module (10) according to any one of the preceding claims, wherein the outer layer (14) is made of a light-opaque material, for example black polycarbonate, and the pictogram (16) is made of a light-transparent or light-translucent material, for example white polycarbonate.

4. Illuminated control module (10) according to any one of the preceding claims, wherein the fascia (12) comprises a light diffusion plate (20), interposed between the outer layer (14) and the flexible printed circuit (18).

5. Illuminated control module (10) according to the preceding claim, wherein the pictogram (16) is located on an outer face (38) of the outer layer (14) and a diffusion barrel (40) extends through the outer layer (14), from the diffusion plate (20) to the pictogram (16).

6. Illuminated control module (10) according to the preceding claim, wherein the diffusion barrel (40) is formed integrally with the diffusion plate (20), for example formed by moulding.

7. Illuminated control module (10) according to any one of the preceding claims, wherein the outer layer (14) is manufactured by dual-injection of a light-transparent or light-translucent material to form the pictogram (16), and a light-opaque material to form the part of the outer layer (14) that is not the pictogram.

8. Illuminated control module (10) according to claim 7 taken in combination with claims 5 or 6, wherein the diffusion plate (20) and the diffusion barrel (40) are manufactured by dual-injection of the light-transparent or light-translucent material.

9. Illuminated control module (10) according to any one of claims 1 to 4, wherein the outer layer (14) is a plastic decorative film.

10. Illuminated control module (10) according to any one of the preceding claims, wherein the light reflector (36) is arranged offset from the light-emitting diode (24).

11. Illuminated control module (10) according to any one of claims 1 to 9, wherein the light reflector (36) comprises at least one portion (42) located facing the light-emitting diode (24) and a portion of the light beam emitted by the light-emitting diode (24) diffuses into the light reflector (36) to be reflected off a surface of the light reflector, then to be diffused through the light reflector (36) towards the pictogram (16).
